# EUROPEAN PATENT APPLICATION

(11) **EP 4 411 791 A1**
(43) Date of publication of application: **07.08.2024**
(21) Application number: 22876200.1
(22) Date of filing: 27.09.2022
(51) Int. Cl.: H01L 21/322, H01L 21/20, H01L 21/205

(54) **EPITAXIAL WAFER AND PRODUCTION METHOD THEREFOR**

(30) Priority: 30.09.2021 JP 2021161813
(71) Applicant: Shin-Etsu Handotai Co., Ltd., Tokyo 100-0004 (JP)
(72) Inventor: SUZUKI, Atsushi, Nishishirakawa-gun, Fukushima 961-8061 (JP); MIZUSAWA, Yasushi, Annaka-shi, Gunma 379-0196 (JP); MATSUBARA, Toshiki, Nishishirakawa-gun, Fukushima 961-8061 (JP); ABE, Tatsuo, Nishishirakawa-gun, Fukushima 961-8061 (JP); OHTSUKI, Tsuyoshi, Nishishirakawa-gun, Fukushima 961-8061 (JP)
(74) Representative: Mooser, Sebastian Thomas
(86) International application number: PCT/JP2022/035882
(87) International publication number: WO 2023/054334

(57) **Abstract**

The present invention is an epitaxial wafer production method, including forming a gettering epitaxial film containing silicon and carbon on a silicon substrate under reduced pressure using a reduced pressure CVD apparatus, and forming a silicon epitaxial film on the gettering epitaxial film. This provides a low-cost, low-contamination carbon-containing epitaxial wafer, and a method for producing such an epitaxial wafer.

## Description

### TECHNICAL FIELD

The present invention relates to an epitaxial wafer and a production method therefor.

### BACKGROUND ART

It has been known that metal contamination degrades the electric properties of semiconductor devices. A widely used technique to reduce the influences of metal contamination is a method of providing metal gettering sites to trap the metal, thereby preventing metal contamination in the device region. A typical example of this technique is metal gettering in the substrate bulk beneath the device region, which utilizes BMD (Bulk Micro Defect).

However, in back-illuminated solid-state imaging devices, there is concern that such a gettering effect in the bulk is reduced due to the structure in which wiring is provided on the front surface and the rear face side is thinned to expose the active layer (photosensitive layer).

For previously-known back-illuminated solid-state imaging devices, a method has been proposed in which carbon is ion-implanted into the surface of a silicon substrate in advance, followed by the epitaxial growth thereon, thereby enhancing the gettering effect primarily through the action of the ion-implanted carbon (Patent Document 1). Although this method is highly effective, the use of an ion implanter introduces problems such as cross-contamination and high costs.

### CITATION LIST

### PATENT LITERATURE

Patent Document 1: JP2015-216327A

### SUMMARY OF INVENTION

### TECHNICAL PROBLEM

The present invention was made in light of the above circumstances, and an object of the present invention is to provide a low-cost and low-contamination carbon-containing epitaxial wafer and a method for producing such an epitaxial wafer.

### SOLUTION TO PROBLEM

In order to achieve the above-mentioned object, the present invention provides an epitaxial wafer production method, comprising forming a gettering epitaxial film containing silicon and carbon on a silicon substrate under reduced pressure using a reduced pressure CVD apparatus, and forming a silicon epitaxial film on the gettering epitaxial film.

Such an epitaxial wafer production method of the present invention performs carbon doping using a reduced pressure CVD apparatus (performs gas doping under reduced pressure), unlike the previously-known method using an ion implanter, and therefore makes it possible to produce a low-cost and low-contamination carbon-containing epitaxial wafer.

At the same time, it is possible to obtain an epitaxial wafer in which carbon is uniformly doped throughout the gettering epitaxial film (in the film thickness direction and in the plane of radial direction), thereby ensuring gettering capability uniform within the plane.

The previously-known method using an ion implanter is capable of implanting carbon only to a certain depth and requires changes in ion implantation conditions if the implantation depth needs to be changed; further, there is a tendency of non-uniformity within the wafer plane. However, the present invention enables gas doping during the growth of gettering epitaxial films, thus more easily achieving uniform carbon doping throughout the entire film thickness direction and radial direction, compared with the previously-known methods.

In this way, an epitaxial wafer of quality equal to or superior to that of previously known wafers, as well as possessing sufficient gettering capability, can be easily obtained.

Further, the gettering epitaxial film may be formed under a pressure of 133 Pa to 10666 Pa (1 Torr to 80 Torr).

In this way, the film thickness of the gettering epitaxial layer and the carbon doping can be made uniform in a simple manner.

Furthermore, the gettering epitaxial film may be formed under a pressure of 667 Pa to 2666 Pa (5 Torr to 20 Torr).

In this way, the film thickness and the carbon doping can be more reliably made uniform.

Further, the gettering epitaxial film may be formed into a film thickness of 0.025 µm to 1 µm.

In this way, sufficient gettering capability can be ensured, and the gettering epitaxial film does not have a thickness larger than necessary, thereby more reliably obtaining an epitaxial wafer at a lower cost.

Furthermore, the gettering epitaxial film may be formed into a film thickness of 0.025 µm to 0.3 µm.

In this way, an epitaxial wafer with sufficient gettering capability can be obtained at an even lower cost.

Further, the gettering epitaxial film may be formed with a carbon atomic concentration of 1.0 × 10¹⁷ atoms/cm³ or more and 5.0 × 10²¹ atoms/cm³ or less.

In this way, sufficient gettering capability can be obtained, and desirable crystallinity is ensured for the silicon epitaxial film on the gettering epitaxial film.

Further, the gettering epitaxial film may be formed with a carbon atomic concentration of 1.0 × 10¹⁹ atoms/cm³ or more and 1.0 × 10²¹ atoms/cm³ or less, and also with a carbon atomic concentration of 1.0 × 10¹⁹ atoms/cm³ or more and 5.0 × 10²⁰ atoms/cm³ or less.

In this way, it is possible to ensure further superior crystallinity of the silicon epitaxial film while providing sufficient gettering capability.

Further, the gettering epitaxial film may be formed at 550°C to 1150°C in a mixed gas atmosphere containing silicon and carbon.

In this way, the formation of the gettering epitaxial film and the carbon doping can be efficiently performed.

Furthermore, the gettering epitaxial film may be formed at 550°C to 800°C in a mixed gas atmosphere containing silicon and carbon.

In this way, the formation of the gettering epitaxial film and the carbon doping can be more efficiently performed.

Further, at least one of SiH₄, SiH₂Cl₂, and SiHCl₃ may be used as a silicon source of the mixed gas atmosphere containing silicon and carbon.

Further, at least one of SiH₃(CH₃), SiH₂(CH₃)₂, SiH(CH₃)₃, CH₄, C₂H₆, and C₃H₈ may be used as a carbon source of the mixed gas atmosphere containing silicon and carbon.

Such a gas is suitable to obtain a gettering epitaxial film containing silicon and carbon.

The present invention also provides an epitaxial wafer, comprising a silicon substrate, a gettering epitaxial film formed of silicon uniformly gas-doped with carbon on the silicon substrate, and a silicon epitaxial film on the gettering epitaxial film.

Such an epitaxial wafer of the present invention is doped with carbon at a low cost and has low contamination. Further, since the carbon is gas-doped uniformly throughout the gettering epitaxial film, the gettering capability is uniform within the plane, and a quality of same as or greater than those from the previously-known technique can be ensured.

Further, the gettering epitaxial film may have a film thickness of 0.025 µm to 1 µm.

This ensures sufficient gettering capability; further, since the gettering epitaxial film does not have a thickness larger than necessary, it is possible to more reliably reduce the cost.

Furthermore, the gettering epitaxial film may have a film thickness of 0.025 µm to 0.3 µm.

This ensures sufficient gettering capability at an even lower cost.

Further, the gettering epitaxial film may have a carbon atomic concentration of 1.0 × 10¹⁷ atoms/cm³ or more and 5.0 × 10²¹ atoms/cm³ or less.

With such a gettering epitaxial film, sufficient gettering capability can be obtained, and desirable crystallinity is ensured for the silicon epitaxial film on the gettering epitaxial film.

Further, the gettering epitaxial film may have a carbon atomic concentration of 1.0 × 10¹⁹ atoms/cm³ or more and 1.0 × 10²¹ atoms/cm³ or less, and also may have a carbon atomic concentration of 1.0 × 10¹⁹ atoms/cm³ or more and 5.0 × 10²⁰ atoms/cm³ or less.

Such a gettering epitaxial film ensures excellent crystallinity of the silicon epitaxial film as well as sufficient gettering capability.

Further, the present invention also provides an epitaxial wafer, comprising a silicon substrate and a gettering epitaxial film formed of silicon uniformly gas-doped with carbon on the silicon substrate, wherein the gettering epitaxial film has an insulation property and a high-frequency property.

Such an epitaxial wafer of the present invention is doped with carbon at a low cost and has low contamination. Further, since the carbon is gas-doped uniformly throughout the gettering epitaxial film, the gettering capability is uniform within the plane, and a quality of same as or greater than those from the previously-known technique can be ensured. Furthermore, the gettering epitaxial film may have an insulation property and a high-frequency property, thus making it suitable for the production of high-frequency devices.

Further, a silicon epitaxial film may be formed on the gettering epitaxial film.

Such an epitaxial wafer has sufficient gettering capability, as well as insulation and high-frequency properties, thereby providing an epitaxial wafer with a silicon epitaxial film suitable for the production of high-frequency devices.

Further, the gettering epitaxial film may be formed with a carbon atomic concentration of 1.0 × 10²⁰ atoms/cm³ or more and 5.0 × 10²¹ atoms/cm³ or less, and also with a carbon atomic concentration of 3.0 × 10²⁰ atoms/cm³ or more and 1.0 × 10²¹ atoms/cm³ or less.

Such a gettering epitaxial film ensures sufficient gettering capability, as well as more reliable insulation and high-frequency properties.

Further, the gettering epitaxial film may have a film thickness of 0.025 µm to 3 µm, and also may have a film thickness of 0.025 µm to 1 µm.

Such a gettering epitaxial film ensures sufficient gettering capability, as well as more reliable insulation and high-frequency properties.

Further, the gettering epitaxial film may be doped with the carbon at a silicon substitution site.

Such a gettering epitaxial film ensures sufficient gettering capability and makes it more suitable for the production of high-frequency devices.

### ADVANTAGEOUS EFFECTS OF INVENTION

The epitaxial wafer and the method for producing the epitaxial wafer of the present invention make it possible to obtain an epitaxial wafer with a carbon-doped gettering epitaxial film beneath a silicon epitaxial film at a low cost and with low contamination. Moreover, carbon can be doped uniformly throughout the entire gettering epitaxial film (both within the plane of radial direction and also in the thickness direction), thereby achieving in-plane uniformity in gettering capability. It is possible to obtain a sufficiently excellent epitaxial wafer also in terms of quality. Furthermore, it is also possible to obtain an epitaxial wafer with an insulation property and a high-frequency property, which is suitable for the production of high-frequency devices.

### BRIEF DESCRIPTION OF DRAWINGS

FIG. 1 is a schematic diagram showing an example of an epitaxial wafer of the present invention.
FIG. 2 is a flow chart showing an example of an epitaxial wafer production method of the present invention.
FIG. 3 is a graph showing the relationship between a carbon doping concentration and concentrations of Ni and Cu in the heat-treated gettering epitaxial film in Examples 1 to 4.
FIG. 4 is a graph showing the relationship between a depth from surface of an epitaxial wafer and concentrations of Ni, Cu, C, and O in Example 1 and Comparative Example.
FIG. 5 is a schematic diagram showing an example of another embodiment of epitaxial wafer of the present invention.
FIG. 6 is a graph showing the relationship of dielectric breakdown voltage at each C concentration in another embodiment.
FIG. 7 is a graph showing the relationship of high-frequency property (2HD) at each C concentration in another embodiment.

### DESCRIPTION OF EMBODIMENTS

The present invention is described in more detail below with reference to the drawings; however, the present invention is not limited to the examples described below.

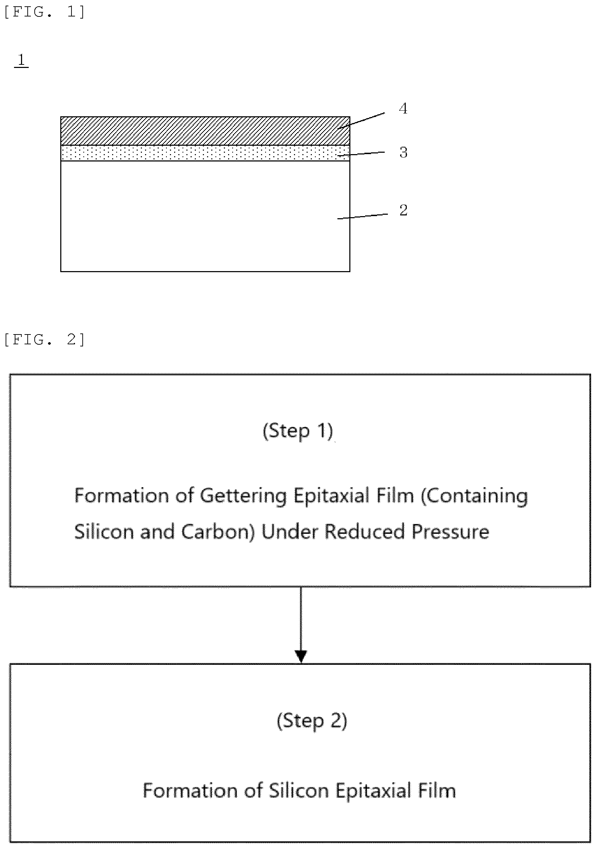

FIG. 1 is a schematic diagram showing an example of an epitaxial wafer of the present invention. This epitaxial wafer 1 of the present invention has a gettering epitaxial film (hereinafter also referred to as a GEP film) 3 containing silicon and carbon, and a silicon epitaxial film 4, which are layered in this order on a silicon substrate 2.

The silicon substrate 2 is not particularly limited and can be obtained by slicing ingots produced by, for example, the Choklarsky or floating zone method, and may have a diameter of, for example, 200 mm, or 300 mm or more.

Further, the silicon epitaxial film 4 is not particularly limited, and may be formed, for example, by a method similar to the previously-known methods. As needed, dopants and the like may be contained.

Further, the GEP film 3 is an epitaxial film made of silicon gas-doped with carbon. Because of gas doping, carbon is uniformly doped throughout the GEP film 3 (i.e., in the film thickness direction and in the plane of radial direction). Therefore, the gettering capability due to the carbon incorporation can also be made uniform within the plane, thus preventing variation of gettering capability within the plane.

On the other hand, in previously-known products, since carbon is doped by ion implantation, the carbon is doped only to a predetermined depth from the surface according to the initial setting. Therefore, the carbon is not uniformly doped for a certain width, especially in the film thickness direction. Uniform doping over a certain width is labor-intensive and also increases the costs. There is also the problem that ion implantation tends to be non-uniform also within the wafer plane.

Further, in contrast to the method using ion implantation (i.e., the technique in which carbon doping is performed using an ion implanter) that easily causes problems in terms of cost and cross-contamination, the present invention can achieve low cost and low contamination.

Thus, it can be said that the product of the present invention is equal to or even superior to the previously-known products in terms of gettering capability, and is also superior to the previously-known products in terms of cost and contamination. Thus, the product of the present invention is an epitaxial wafer with excellent quality.

The film thickness of the GEP film 3 is not particularly limited; however, the film thickness may be, for example, 0.025 µm to 1 µm, more preferably 0.025 um to 0.3 um. Such a film thickness ensures sufficient gettering capability at an even lower cost.

Further, although the carbon atomic concentration thereof is not particularly limited; the carbon atomic concentration may be, for example, in the range of 1.0 × 10¹⁷ atoms/cm³ or more and 5.0 × 10²¹ atoms/cm³ or less, further preferably in the range of 1.0 × 10¹⁹ atoms/cm³ or more and 1.0 × 10²¹ atoms/cm³ or less, and further more preferably in the range of 1.0 × 10¹⁹ atoms/cm³ or more and 5.0 × 10²⁰ atoms/cm³ or less. Such a carbon atomic concentration ensures further superior gettering capability and crystallinity of the silicon epitaxial film 4, resulting in further higher quality.

Such an epitaxial wafer 1 of the present invention is suitable for, for example, the production of back-illuminated solid-state imaging devices; however, the use thereof is not particularly limited.

FIG. 2 is a flow chart showing an example of an epitaxial wafer production method of the present invention, which can produce the epitaxial wafer 1 of the present invention.

### <Step 1: Formation of Gettering Epitaxial Film (Containing Silicon and Carbon) Under Reduced Pressure>

First, the silicon substrate 2 such as one described above is prepared, and the GEP film 3 is formed by epitaxial growth under reduced pressure using a reduced pressure CVD apparatus (hereinafter also referred to as a RP-CVD apparatus). For example, reduced pressure CVD apparatuses similar to those previously used can be used.

As described above, the present invention performs the carbon doping of the GEP film 3 by a method in which gas doping is performed upon epitaxial growth under reduced pressure using a reduced pressure CVD apparatus, instead of the method of ion implantation of carbon using an ion implanter as in the previously-known technique. Such a method of the present invention can be performed at a cost lower than that of the previously-known technique. Further, it is also possible to prevent the occurrence of cross-contamination problems that can arise from the use of ion implanter used in another process. Furthermore, carbon can be doped more uniformly throughout the GEP film 3 compared to the previously-known method, and the gettering capability by the GEP film 3 can be easily provided at the same or higher level compared to the previously-known method, thereby obtaining a high-quality GEP film 3 and a high-quality epitaxial wafer 1.

At least one of SiH₄, SiH₂Cl₂, and SiHCl₃ can be used as the silicon source gas in the mixed gas atmosphere to form the GEP film 3, and at least one of SiH₃(CH₃), SiH₂(CH₃)₂, SiH(CH₃)₃, CH₄, C₂H₆, and C₃H₈ can be used as the carbon source gas for doping. There is no particular limitation as long as the raw material gas or doping gas capable of gas doping of carbon while forming a silicon epitaxial film is used; however, the source gases mentioned above are suitable as they are commonly used and are readily available.

The pressure in the chamber of the reduced pressure CVD apparatus at this time is not particularly limited as long as it is a reduced-pressure state; however, the pressure may be, for example, 133 Pa to 10666 Pa (1 Torr to 80 Torr), more preferably 667 Pa to 2666 Pa (5 Torr to 20 Torr). Such epitaxial growth under reduced pressure makes it possible to achieve uniform film thickness and carbon doping of the GEP layer 3 more easily and reliably.

Further, the holding temperature in the chamber may be set to, for example, 550°C to 1150°C, for efficient film formation and carbon doping. The film formation and carbon doping may be even more efficiently performed at a temperature between 550°C and 800°C.

In this way, a GEP film 3 of excellent quality with the film thickness and carbon atomic concentration mentioned above can be obtained. The film thickness and carbon atomic concentration can be adjusted, for example, by adjusting the duration of processing time or the amount of source gas introduced.

### <Step 2: Formation of Silicon Epitaxial Film>

Next, the silicon epitaxial film 4 is formed. This method for forming the silicon epitaxial film 4 is not particularly limited and the silicon epitaxial film 4 can be formed by a method similar to the previously-known methods. For example, the formation may be performed by introducing the silicon source gas mentioned above into the chamber under a holding temperature at around 1000°C. By controlling the processing time and the doping gas for resistivity adjustment, the silicon epitaxial film 4 with a desired film thickness, conductivity type, and resistivity can be formed on the GEP film 3.

In this manner, the epitaxial wafer 1 of the present invention can be obtained.

The following describes another embodiment of the present invention.

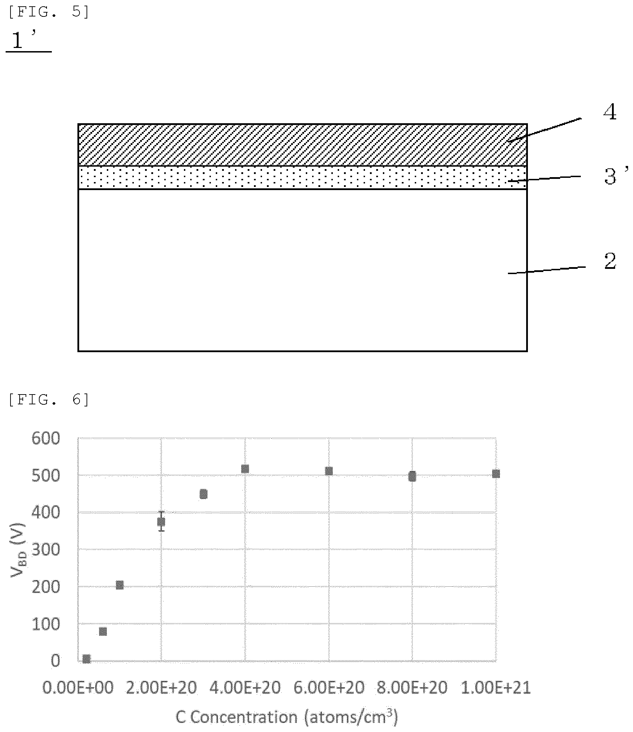

FIG. 5 shows an example of an epitaxial wafer of another embodiment of the present invention. This epitaxial wafer 1' of the present invention has a gettering epitaxial film (GEP film) 3' containing silicon and carbon, and the silicon epitaxial film 4, which are layered in this order on the silicon substrate 2.

The silicon substrate 2 and the silicon epitaxial film 4 may be the same as those in the embodiment in FIG. 1.

Further, the GEP film 3' is an epitaxial film formed of silicon gas-doped with carbon. The GEP film 3' is uniformly doped with carbon, and the gettering capability due to the carbon incorporation is also made uniform within the plane. Moreover, the GEP film 3' has an insulation property and a high-frequency property.

Such an epitaxial wafer 1' of the present invention is suitable for, for example, the production of high-frequency devices; however, the use thereof is not particularly limited.

Further, although the example with the silicon epitaxial film 4 is described above, a structure having only the silicon substrate 2 and the GEP film 3' may be used.

The carbon atomic concentration of the GEP film 3' is not particularly limited; however, the carbon atomic concentration of the GEP film 3' may be, for example, in the range of 1.0 × 10²⁰ atoms/cm³ or more to 5.0 × 10²¹ atoms/cm³ or less, more preferably in the range of 3.0 × 10²⁰ atoms/cm³ or more to 1.0 × 10²¹ atoms/cm³ or less. Such a carbon atomic concentration ensures further superior gettering capability and crystallinity of the silicon epitaxial film 4, resulting in further higher quality. Moreover, the insulation property and the high-frequency property become more reliable.

Further, the film thickness of the GEP film 3' is not particularly limited; however, the film thickness may be, for example, 0.025 µm to 3 µm, more preferably 0.025 µm to 1 µm. Such a film thickness ensures sufficient gettering capability at an even lower cost. Moreover, the insulation property and the high-frequency property become more reliable.

Further, the GEP film 3' may be doped with carbon at a silicon substitution site. In this case, the gettering capability and the suitability for the production of high-frequency devices are further improved.

By adjusting the film thickness and the carbon atomic concentration by, for example, adjusting the duration of the processing time and the amount of source gas introduced, in the method of producing the epitaxial wafer 1 in FIG. 1 described above, it is possible to obtain the epitaxial wafer 1' of the present invention such as the one shown in FIG. 5. In the gas doping described above, the carbon doping is usually done at the silicon substitution site; however, the carbon gas doping may be done also in interstitial sites.

Here, the insulation property of the epitaxial wafer 1' of the present invention is investigated.

In this investigation, a structure consisting only of the silicon substrate 2 and the GEP film 3' was used. The film thickness of the GEP film 3' was 1 µm. The carbon atomic concentration in the GEP film 3' was actually changed to investigate the voltage at which breakage can be withstood. FIG. 6 shows the results (dielectric breakdown voltage). The horizontal axis represents the carbon atomic concentration and the vertical axis represents the dielectric breakdown voltage value (V_{BD}).

The combinations of (carbon atomic concentration: V_{BD}) are as follows. (2.0 × 10¹⁹ atoms/cm³: 5V), (6.0 × 10¹⁹ atoms/cm³: 80V), (1.0 × 10²⁰ atoms/cm³: 205V), (2.0 × 10²⁰ atoms/cm³: 375V), (3.0 × 10²⁰ atoms/cm³: 450V), (4.0 × 10²⁰ atoms/cm³: 515V), (6.0 × 10²⁰ atoms/cm³: 510V), (8.0 × 10²⁰ atoms/cm³: 495V), (1.0 × 10²¹ atoms/cm³: 500V) .

For example, a value of 1.0 × 10²⁰ atoms/cm³ or higher ensures a dielectric breakdown voltage characteristic of 205V or more, thereby obtaining a further superior insulation property. Since the dielectric breakdown voltage is about the same between 4.0 × 10²⁰ to 1.0 × 10²¹ atoms/cm³, it can be said that 5.0 × 10²¹ atoms/cm³ is sufficient even considering the margin.

Further, the high-frequency property of the epitaxial wafer 1' of the present invention was also investigated.

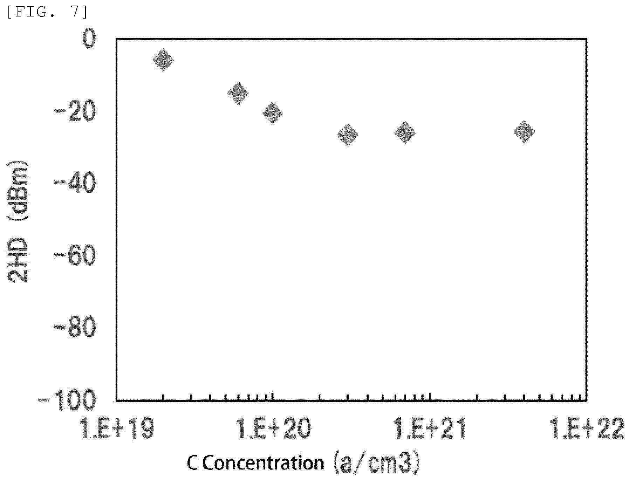

Here, the resistivity of the silicon substrate 2 was set to 10 Ω·cm, and a structure in which only the GEP film 3' is formed on the silicon substrate 2 was used. The film thickness of the GEP film 3' was 1 um. In addition to the actual change in the carbon atomic concentration in the GEP film 3', a Co-Planar Waveguide (CPW) was formed to evaluate the second harmonic (2HD) property. FIG. 7 shows the results (2HD property). The horizontal axis represents the carbon atomic concentration and the vertical axis represents 2HD.

The combinations of (carbon atomic concentration: 2HD) are as follows. (2.0 × 10¹⁹ atoms/cm³: -5 dBm), (6.0 × 10¹⁹ atoms/cm³: -18 dBm), (1.0 × 10²⁰ atoms/cm³: - 20 dBm), (3.0 × 10²⁰ atoms/cm³: -28 dBm), (7.0 × 10²⁰ atoms/cm³: -28 dBm), (4.0 × 10²¹ atoms/cm³: -28 dBm).

Even at around 2.0 × 10¹⁹ atoms/cm³, a 2HD property of -5 dBm was obtained; further, for example, with a value of 1.0 × 10²⁰ atoms/cm³ or more, a 2HD property of -20 dBm or less was obtained, thereby obtaining a further superior high-frequency property. Since the 2HD property was about the same between 3.0 × 10²⁰ to 4.0 × 10²¹ atoms/cm³, it can be said that 5.0 × 10²¹ atoms/cm³ is sufficient even considering the margin.

### EXAMPLES

The following Examples and Comparative Examples of the present invention are given to illustrate the present invention in more detail. However, the present invention is not limited to these Examples and Comparative Examples.

### (Example 1)

0.3 um of a gettering epitaxial film (carbon atomic concentration: 2 × 10¹⁹ atoms/cm³: measured by SIMS) containing silicon and carbon was formed on a silicon substrate having a diameter of 300 mm using an RP-CVD apparatus at 800°C under a reduced pressure of 667 Pa (5 Torr) in a mixed gas atmosphere containing SiH₄ and SiH₃(CH₃), and a silicon epitaxial film (film thickness: 9 µm) was formed on the gettering epitaxial film to produce the epitaxial wafer of the present invention.

To evaluate the gettering capability of the gettering epitaxial film of the epitaxial wafer, the obtained epitaxial wafer was intentionally contaminated with Ni and Cu. Specifically, an aqueous nitric acid solution containing 1000 ppb of Cu and an aqueous nitric acid solution containing 1000 ppb of Ni were prepared, and only 10 ml of each solution was added dropwise onto the wafer, and was applied over the entire surface using a spin coater. The resulting wafer was dried naturally and was subjected to a heat treatment in a heat treatment furnace at 1000°C for 30 minutes in a nitrogen atmosphere. The Ni and Cu concentrations in the gettering epitaxial film after the heat treatment were 7.0 × 10¹⁶ atoms/cm³ and 6.0 × 10¹⁶ atoms/cm³, respectively.

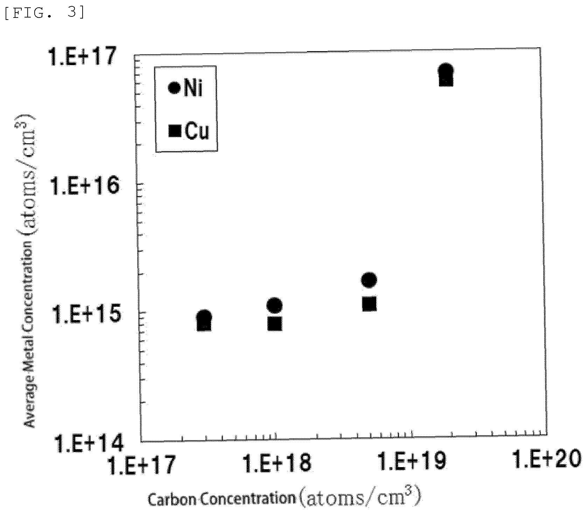

FIG. 3 is a graph showing the relationship between the carbon doping concentration and concentrations of Ni and Cu in the heat-treated gettering epitaxial film in Example 1, and Examples 2 to 4 described later.

### (Example 2)

As the epitaxial wafer to be evaluated, an epitaxial wafer was produced under the same conditions as those in Example 1, except that the carbon atomic concentration of the gettering epitaxial film was 5 × 10¹⁸ atoms/cm³, followed by intentional contamination and heat treatment. The carbon atomic concentration was adjusted by changing the amounts of SiH₄ and SiH₃(CH₃) introduced.

The Ni and Cu concentrations in the heat-treated gettering epitaxial film were 1.7 × 10¹⁵ atoms/cm³ and 1.1 × 10¹⁵ atoms/cm³, respectively.

### (Example 3)

As the epitaxial wafer to be evaluated, an epitaxial wafer was produced under the same conditions as those in Example 1, except that the carbon atomic concentration of the gettering epitaxial film was 1 × 10¹⁸ atoms/cm³, followed by intentional contamination and heat treatment. The carbon atomic concentration was adjusted by changing the amounts of SiH₄ and SiH₃(CH₃) introduced.

The Ni and Cu concentrations in the heat-treated gettering epitaxial film were 1.1 × 10¹⁵ atoms/cm³ and 7.9 × 10¹⁴ atoms/cm³, respectively.

### (Example 4)

As the epitaxial wafer to be evaluated, an epitaxial wafer was produced under the same conditions as those in Example 1, except that the carbon atomic concentration of the gettering epitaxial film was 3 × 10¹⁷ atoms/cm³, followed by intentional contamination and heat treatment. The carbon atomic concentration was adjusted by changing the amounts of SiH₄ and SiH₃(CH₃) introduced.

The Ni and Cu concentrations in the heat-treated gettering epitaxial film were 9.2 × 10¹⁴ atoms/cm³ and 8.1 × 10¹⁴ atoms/cm³, respectively.

### (Comparative Example)

A silicon epitaxial wafer with a carbon-containing layer (carbon atomic concentration: 3 × 10¹⁹ atoms/cm³), which was fabricated by ion implantation of carbon into a silicon epitaxial wafer using an ion implanter at an acceleration voltage of 32 keV and a dose of 1 × 10¹⁵ atoms/cm², was prepared. Intentional contamination and heat treatment were performed under the same conditions as those in Example 1.

The silicon epitaxial wafer in which carbon is ion-implanted is a wafer having a silicon epitaxial film (film thickness: 9 µm) formed on a silicon substrate, as in Example 1. The depth of ion implantation (position of the carbon-containing layer) is 9 um deep from the surface of the silicon epitaxial film, and the thickness of the carbon-containing layer is 0.1 µm.

The Ni and Cu concentrations in the heat-treated carbon-containing layer (gettering epitaxial film) were 1.0 × 10¹⁷ atoms/cm³ and 4.0 × 10¹⁶ atoms/cm³, respectively.

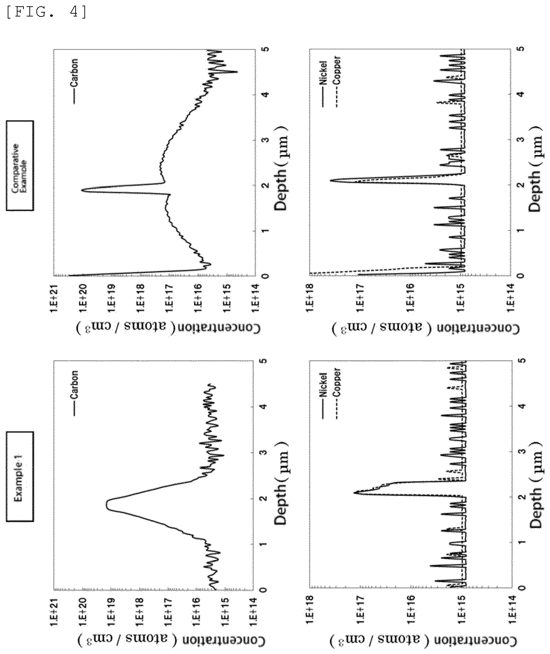

Further, FIG. 4 is a graph showing the relationship between the depth from the surface of the epitaxial wafer and concentrations of Ni, Cu, C, and O in Example 1 and Comparative Example. In each of Example 1 and Comparative Example, a peak of C concentration can be observed, especially around 2 um depth. Since the surface layer was polished by 7 um before the concentration was measured by SIMS, the depth (µm) in the horizontal axis of FIG. 4 is a value obtained by subtracting 7 um from the actual depth before the polishing. That is, the 2 µm depth position shown in FIG. 4 means a 9 µm depth position before the polishing.

Although the value of the peak concentration is different, Example 1 shows a thick peak with a width of about 0.3 um as well as uniform doping throughout its gettering epitaxial film, whereas only a narrow peak of 0.1 um was obtained in Comparative Example. In the C concentration of Example 1, the gettering epitaxial film has thickness of 0.3 um, and, from that depth position as the center, it relatively gradually extends to the shallow and deep directions. On the other hand, the C concentration in Comparative Example is steeper near the peak.

Also, the peaks of the Ni and Cu concentrations are at about the substantially same depth as that near the peak of the C concentration. The Ni and Cu concentrations (7.0 × 10¹⁶ atoms/cm³, 6.0 × 10¹⁶ atoms/cm³) in the gettering epitaxial film in Example 1 shown above and the Ni and Cu concentrations (1.0 × 10¹⁷ atoms/cm³, 4.0 × 10¹⁶ atoms/cm³) in the carbon-containing layer (gettering epitaxial film) in Comparative Example are the average concentrations at depths of 2 um to 2.5 um.

FIG. 4 reveals that Ni and Cu were captured over a wider area in the depth direction in Example 1, compared with Comparative Example 1. This may be the reason why Ni and Cu were captured at similar average concentration levels even though the peak value of the C concentration in Example 1 is lower than that in Comparative Example (and the peak values of the Ni and Cu concentrations are also lower).

In FIG. 4, the position of the depth of the C concentration peak and the positions of the depths of the Ni and Cu concentration peaks are slightly different. This is presumably due to influence of stress distortion by the difference in thermal expansion coefficients or defects caused by the stress distortion at the interface between the silicon substrate and the carbon-containing gettering epitaxial film.

As evident from Example 1 and Comparative Example, the epitaxial wafer production method of the present invention makes it possible to produce products with a gettering capability equal to or superior to that of previously known products. Moreover, the present invention enables low cost production and prevents cross-contamination that can occur when ion implanters are used.

Further, as shown in Examples 1 to 4, the carbon atomic concentration in the gettering epitaxial film can be adjusted in various ways as needed, thereby adjusting the gettering capability as needed.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. An epitaxial wafer production method, comprising forming a gettering epitaxial film containing silicon and carbon on a silicon substrate under reduced pressure using a reduced pressure CVD apparatus, and forming a silicon epitaxial film on the gettering epitaxial film.

2. The epitaxial wafer production method according to claim 1, wherein the gettering epitaxial film is formed under a pressure of 133 Pa to 10666 Pa.

3. The epitaxial wafer production method according to claim 1 or 2, wherein the gettering epitaxial film is formed under a pressure of 667 Pa to 2666 Pa.

4. The epitaxial wafer production method according to any one of claims 1 to 3, wherein the gettering epitaxial film is formed into a film thickness of 0.025 µm to 1 µm.

5. The epitaxial wafer production method according to any one of claims 1 to 4, wherein the gettering epitaxial film is formed into a film thickness of 0.025 um to 0.3 um.

6. The epitaxial wafer production method according to any one of claims 1 to 5, wherein the gettering epitaxial film is formed with a carbon atomic concentration of 1.0 × 10¹⁷ atoms/cm³ or more and 5.0 × 10²¹ atoms/cm³ or less.

7. The epitaxial wafer production method according to any one of claims 1 to 6, wherein the gettering epitaxial film is formed with a carbon atomic concentration of 1.0 × 10¹⁹ atoms/cm³ or more and 1.0 × 10²¹ atoms/cm³ or less.

8. The epitaxial wafer production method according to any one of claims 1 to 7, wherein the gettering epitaxial film is formed with a carbon atomic concentration of 1.0 × 10¹⁹ atoms/cm³ or more and 5.0 × 10²⁰ atoms/cm³ or less.

9. The epitaxial wafer production method according to any one of claims 1 to 8, wherein the gettering epitaxial film is formed at 550°C to 1150°C in a mixed gas atmosphere containing silicon and carbon.

10. The epitaxial wafer production method according to any one of claims 1 to 9, wherein the gettering epitaxial film is formed at 550°C to 800°C in a mixed gas atmosphere containing silicon and carbon.

11. The epitaxial wafer production method according to claim 9 or 10, wherein at least one of SiH₄, SiH₂Cl₂, and SiHCl₃ is used as a silicon source of the mixed gas atmosphere containing silicon and carbon.

12. The epitaxial wafer production method according to any one of claims 9 to 11, wherein at least one of SiH₃(CH₃), SiH₂(CH₃)₂, SiH(CH₃)₃, CH₄, C₂H₆, and C₃H₈ is used as a carbon source of the mixed gas atmosphere containing silicon and carbon.

13. An epitaxial wafer, comprising a silicon substrate, a gettering epitaxial film formed of silicon uniformly gas-doped with carbon on the silicon substrate, and a silicon epitaxial film on the gettering epitaxial film.

14. The epitaxial wafer according to claim 13, wherein the gettering epitaxial film has a film thickness of 0.025 µm to 1 µm.

15. The epitaxial wafer according to claim 13 or 14, wherein the gettering epitaxial film has a film thickness of 0.025 um to 0.3 um.

16. The epitaxial wafer according to any one of claims 13 to 15, wherein the gettering epitaxial film has a carbon atomic concentration of 1.0 × 10¹⁷ atoms/cm³ or more and 5.0 × 10²¹ atoms/cm³ or less.

17. The epitaxial wafer according to any one of claims 13 to 16, wherein the gettering epitaxial film has a carbon atomic concentration of 1.0 × 10¹⁹ atoms/cm³ or more and 1.0 × 10²¹ atoms/cm³ or less.

18. The epitaxial wafer according to any one of claims 13 to 17, wherein the gettering epitaxial film has a carbon atomic concentration of 1.0 × 10¹⁹ atoms/cm³ or more and 5.0 × 10²⁰ atoms/cm³ or less.

19. An epitaxial wafer, comprising a silicon substrate, and a gettering epitaxial film formed of silicon uniformly gas-doped with carbon on the silicon substrate,
wherein
the gettering epitaxial film has an insulation property and a high-frequency property.

20. The epitaxial wafer according to claim 19, further comprising a silicon epitaxial film on the gettering epitaxial film.

21. The epitaxial wafer according to claim 19 or 20, wherein the gettering epitaxial film has a carbon atomic concentration of 1.0 × 10²⁰ atoms/cm³ or more and 5.0 × 10²¹ atoms/cm³ or less.

22. The epitaxial wafer according to any one of claims 19 to 21, wherein the gettering epitaxial film has a carbon atomic concentration of 3.0 × 10²⁰ atoms/cm³ or more and 1.0 × 10²¹ atoms/cm³ or less.

23. The epitaxial wafer according to any one of claims 19 to 22, wherein the gettering epitaxial film has a film thickness of 0.025 µm to 3 µm.

24. The epitaxial wafer according to any one of claims 19 to 23, wherein the gettering epitaxial film has a film thickness of 0.025 µm to 1 µm.

25. The epitaxial wafer according to any one of claims 19 to 24, wherein the gettering epitaxial film is doped with the carbon at a silicon substitution site.
